# EUROPEAN PATENT APPLICATION

(11) **EP 4 808 302 A1**
(43) Date of publication of application: **16.09.2026**
(21) Application number: 26163727.6
(22) Date of filing: 10.03.2026
(51) Int. Cl.: H05K 7/20

(54) **VORTEX TUBE COOLING SYSTEM FOR DATA CENTERS**

(30) Priority: 12.03.2025 US 202519077916
(71) Applicant: Aivres Systems Inc., Fremont California 94538 (US)
(72) Inventor: HUANG, Yu-Hsien, Fremont, 94538 (US)
(74) Representative: Marks & Clerk LLP

(57) **Abstract**

A cooling system for managing thermal conditions in a data center is disclosed. The system comprises a high-pressure air pipeline integrated into a server rack, at least one vortex tube cooler connected to the high-pressure air pipeline, a cold airflow distribution assembly, and a hot airflow exhaust assembly. The vortex tube cooler is configured to generate a cold airflow and a hot airflow from the supplied compressed air. The cold airflow distribution assembly directs the cold airflow toward the intake fans of servers positioned in the server rack, ensuring efficient and even cooling without direct thermal shock to electronic components. The hot airflow exhaust assembly vents the hot airflow away from the server rack, preventing localized heat buildup.

## Description

### TECHNICAL FIELD

The present invention relates to thermal management systems for data centers, specifically to a targeted cooling system utilizing vortex tube technology to enhance airflow efficiency, eliminate localized hotspots, and improve the overall thermal stability of server racks.

### BACKGROUND

Data centers house large numbers of computing servers that generate substantial amounts of heat during operation. To maintain system stability and prevent thermal damage, efficient cooling mechanisms are essential. Conventional data center cooling systems primarily rely on large air conditioning units that distribute cooled air through raised floor ducts. In a typical setup, server racks are positioned in rows, with cold air supplied from the floor and drawn into the front of the servers. The servers then expel hot air from the rear, which is removed through ceiling ducts.

While this approach is widely used, it suffers from several inherent inefficiencies. One major issue is airflow imbalance, which leads to the formation of hotspots in certain areas of the data center. Upper-layer servers and racks located at the end of cooling ducts often receive insufficient cooling, as the lower racks absorb most of the cold air first. These temperature disparities result in inconsistent thermal conditions, reduced cooling efficiency, and increased wear on hardware components. To compensate for these inefficiencies, operators frequently resort to manual interventions such as adjusting airflow deflectors, repositioning fans, or modifying dampers, which are labor-intensive and often inadequate for high-density server environments.

To address these limitations, this disclosure describes a targeted and scalable cooling solution that integrates vortex tube technology into server racks, leveraging existing high-pressure air pipelines to enhance cooling efficiency and reliability.

### SUMMARY

A system comprising one or more computers may be configured to perform specific operations by utilizing software, firmware, hardware, or a combination thereof. The system executes these operations through installed components that, when in operation, enable it to perform the specified actions. Similarly, one or more computer programs may be configured to execute specific operations by containing instructions that, when processed by a data processing apparatus, cause it to carry out the intended functions.

In one general aspect, a cooling system may include a high-pressure air pipeline integrated into a server rack. The cooling system may also include at least one vortex tube cooler connected to the high-pressure air pipeline, where the vortex tube cooler is configured to generate a cold airflow and a hot airflow. Additionally, the system may include a cold airflow distribution assembly connected to the vortex tube cooler, directing the cold airflow toward servers within the server rack. Furthermore, the system may include a hot airflow exhaust assembly connected to the vortex tube cooler, designed to vent the hot airflow away from the server rack. Other embodiments of this aspect may include corresponding computer systems, apparatus, and computer programs stored on one or more computer storage devices, each configured to execute the described methods.

Implementations may include one or more of the following features. The cooling system may include a control system operatively coupled to the high-pressure air pipeline and configured to regulate airflow through the vortex tube cooler based on real-time thermal conditions within the server rack. In some implementations, the control system may include an adjustable valve for modifying the airflow. The control system may also be configured to receive input from temperature sensors located within the server rack, allowing it to dynamically adjust the airflow through the vortex tube cooler. Additionally, the control system may be communicatively linked to a data center's environmental control system to synchronize cooling operations with overall data center thermal management.

The cooling system may further include an air compressor configured to generate compressed air and supply it to the vortex tube cooler, facilitating the production of cold and hot airflows. In some implementations, the high-pressure air pipeline may be integrated with an existing compressed air supply in the data center. The vortex tube cooler may be positioned at a lower section of the server rack to optimize airflow distribution. The cold airflow distribution assembly may include cold air spray outlets located adjacent to the intake fans of the servers. The cold airflow sprayed from the outlets may mix with ambient air before entering the intake fans, preventing direct thermal shock to electronic components.

To manage heat dissipation, the hot airflow exhaust assembly may incorporate a ducting system that directs the hot airflow away from heat-sensitive components within the server rack. The vortex tube cooler may operate without requiring electrical power, relying solely on compressed air to generate the cold airflow. Additionally, the cooling system may include a fail-safe cooling mechanism that activates the vortex tube cooler in response to an air conditioning system failure, ensuring emergency cooling to prevent server overheating.

The vortex tube cooler may be designed to adjust the cold airflow temperature to prevent condensation and minimize thermal expansion and contraction effects on the servers. The server rack may include multiple vortex tube coolers, each strategically positioned to provide targeted cooling to specific heat-generating components within the servers. The vortex tube cooler may also be adjustable to vary the proportion of cold and hot airflow based on cooling demands.

In some implementations, the cold airflow distribution assembly may extend outward from the vortex tube cooler and bend upwards to direct cold airflow toward the intake fans of the servers positioned on the server rack. The cooling system may also include a high-pressure air tank configured to store compressed air and release it into the vortex tube cooler, ensuring a continuous supply of compressed air for generating cold and hot airflow. Additionally, the vortex tube cooler may feature an adjustable spray outlet that allows manual or automated control over the direction and spread of the cold airflow toward different regions within the server rack. Implementations of the described techniques may include hardware, a method or process, or a computer-readable medium.

In one general aspect, a method may include supplying compressed air from a high-pressure air pipeline integrated into a server rack to at least one vortex tube cooler. The method may also include generating, by the vortex tube cooler, a cold airflow and a hot airflow from the supplied compressed air. Furthermore, the method may involve directing the cold airflow through a cold airflow distribution assembly toward the intake fans of servers positioned in the server rack. Additionally, the method may include venting the hot airflow away from the server rack through a hot airflow exhaust assembly. Moreover, the method may involve adjusting the supply of compressed air to the vortex tube cooler based on real-time thermal conditions detected within the server rack. Other embodiments of this aspect may include corresponding computer systems, apparatus, and computer programs stored on one or more computer storage devices, each configured to execute the described methods.

### BRIEF DESCRIPTION OF THE DRAWINGS

Certain features of various embodiments of the present technology are set forth with particularity in the appended claims. A better understanding of the features and advantages of the technology will be obtained by reference to the following detailed description that sets forth illustrative embodiments, in which the principles of the disclosure are utilized, and the accompanying drawings of which:
FIG. 1 shows an example plan view of a server room layout.
FIG. 2 is an example cross-sectional view of a cooling system using cold and hot airflow ducts for managing thermal conditions in a data center, according to one example embodiment.
FIG. 3 is an example cross-sectional view of a cooling system using high-pressure air pipeline for managing thermal conditions in a data center, according to one example embodiment.
FIG. 4 is an example cross-sectional view of a vortex tube cooler, according to one example embodiment.
FIG. 5 is an example configuration of the vortex tube cooler and the high-pressure pipeline, according to one example embodiment.
FIG. 6 illustrates an example cross-sectional view of a server rack using the high-pressure air pipeline for managing thermal conditions, according to one example embodiment.
FIG. 7 illustrates another example cross-sectional view of a server rack using the high-pressure air pipeline for managing thermal conditions, according to one example embodiment.
FIG. 8 illustrates an example method for cooling servers in a data center using the high-pressure air pipeline, according to one example embodiment.
FIG. 9 illustrates an example configuration of the cooling system in a data center, according to one example embodiment.

### DETAILED DESCRIPTION OF EMBODIMENTS

In the following description, certain specific details are set forth in order to provide a thorough understanding of various embodiments of the disclosure. However, one skilled in the art will understand that the disclosure may be practiced without these details. Moreover, while various embodiments of the disclosure are disclosed herein, many adaptations and modifications may be made within the scope of the disclosure in accordance with the common general knowledge of those skilled in this art. Such modifications include the substitution of known equivalents for any aspect of the disclosure in order to achieve the same result in substantially the same way.

Unless the context requires otherwise, throughout the present specification and claims, the word "comprise" and variations thereof, such as, "comprises" and "comprising" are to be construed in an open, inclusive sense, that is as "including, but not limited to." Recitation of numeric ranges of values throughout the specification is intended to serve as a shorthand notation of referring individually to each separate value falling within the range inclusive of the values defining the range, and each separate value is incorporated in the specification as it were individually recited herein. Additionally, the singular forms "a," "an" and "the" include plural referents unless the context clearly dictates otherwise.

Reference throughout this specification to "one embodiment" or "an embodiment" means that a particular feature, structure or characteristic described in connection with the embodiment is included in at least one embodiment of the present disclosure. Thus, the appearances of the phrases "in one embodiment" or "in an embodiment" in various places throughout this specification are not necessarily all referring to the same embodiment, but may be in some instances. Furthermore, the particular features, structures, or characteristics may be combined in any suitable manner in one or more embodiments.

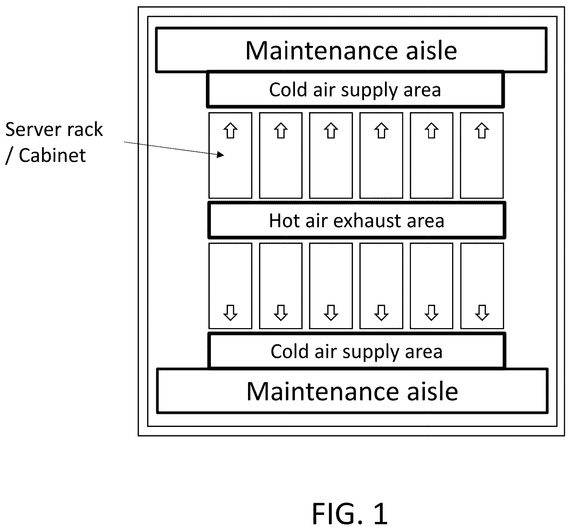

FIG. 1 shows an example plan view of a server room layout. The server room is a dedicated space designed for the continuous operation of computer servers and may serve as a large-scale data center, a private enterprise-operated data center, or an AI-focused data center built for high-speed data transmission and parallel computing. In modem AI data centers, where vast numbers of servers work together to process computationally intensive tasks, a well-planned infrastructure is critical to ensuring stability, efficiency, and optimal cooling performance.

As depicted in FIG. 1, the example server room includes two maintenance aisles, one on each side, providing access for personnel to service and manage the server racks. Between the maintenance aisles, there are two rows of server racks or cabinets, which house multiple rack-mounted servers. The server racks are positioned on an elevated floor, allowing for the integration of electrical, networking, and cooling infrastructure beneath them.

Each row of server racks includes a cold air supply area on the outer side, adjacent to the corresponding maintenance aisle. Cold air is delivered through air supply ducts positioned under the elevated floor, with vents located in front of the server racks (e.g., the side next to the cold air supply). The servers draw in this cold air from the front, ensuring efficient cooling of internal components.

Between the two rows of server racks, there is a hot air exhaust area, where the heated air expelled from the rear of the servers accumulates. This hot air is then extracted through ceiling-mounted exhaust ducts, ensuring efficient heat dissipation and preventing temperature buildup in the server room.

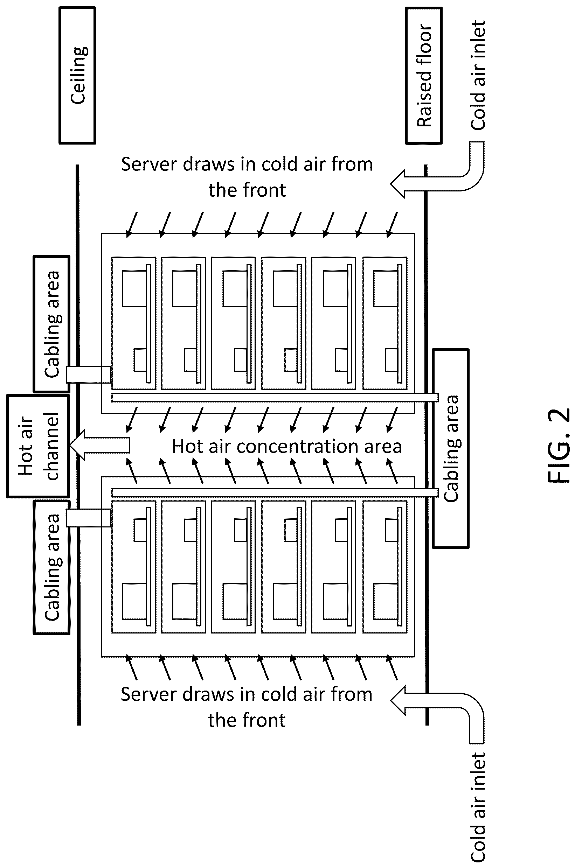

FIG. 2 is an example cross-sectional view of a cooling system using cold and hot airflow ducts for managing thermal conditions in a data center, according to one example embodiment. The cross-sectional view in FIG. 2 is another perspective of the plan view in FIG. 1, illustrating the vertical arrangement of cooling components and airflow pathways within the server room.

As shown in FIG. 2, the data center includes two server racks, each hosting a plurality of servers arranged in a vertical stack. Positioned on the outer side of each server rack is a cold air inlet, which supplies chilled air to the servers. The cold air enters the system from vents located in the elevated floor, ensuring a continuous supply of conditioned air to the servers. The servers draw in cold air from the front, effectively cooling the internal electronic components before expelling hot air from the back.

The expelled hot air from both server racks converges in the middle of the data center, forming a hot air concentration area. This controlled separation of cold air intake and hot air exhaust follows a structured hot aisle/cold aisle cooling configuration, optimizing thermal efficiency and preventing hot and cold air from mixing prematurely.

Beneath the raised floor, a dedicated cabling area is reserved to house electrical and networking infrastructure that powers and connects the servers while keeping critical wiring separate from airflow pathways.

Near the ceiling area, additional cabling areas and a hot air channel are positioned to manage the organized routing of power and network connections. The hot air channel collects the heated exhaust air from the hot air concentration area and vents it outside of the server room.

While the cooling system illustrated in FIG. 2 is widely adopted in conventional server room designs, it presents several technical challenges. The primary cooling mechanism relies on air cooling, where cold air is drawn in from the server room environment at the front of the server and expelled as waste heat from the back. However, a fundamental issue arises because cold air is supplied from vents in the raised floor, blowing upward. Upper-row servers often struggle to receive sufficiently cold air, and if a server rack is located at the end of an air supply duct, the servers in that rack may intake warmer ambient air, leading to higher operating temperatures and reduced cooling efficiency.

This airflow imbalance leads to localized hotspot issues within the server room. In many cases, manual interventions such as adjusting air conditioning deflectors, modifying air dampers, or even installing additional electric fans are necessary to redirect cold air flow to these hotspots. However, such solutions are inefficient and difficult to scale in high-density server environments. Localized hotspots not only reduce server performance and operational efficiency but also shorten the lifespan of server equipment due to prolonged exposure to elevated temperatures.

Furthermore, as server power consumption continues to increase annually, high-density, high-power servers enable data centers to maximize their processing capacity within a smaller footprint. While this improves space utilization, it also significantly reduces the response time for system failures. If power supply or air conditioning systems fail, accumulated heat inside the servers cannot be dissipated in time, potentially resulting in server shutdowns and operational disruptions.

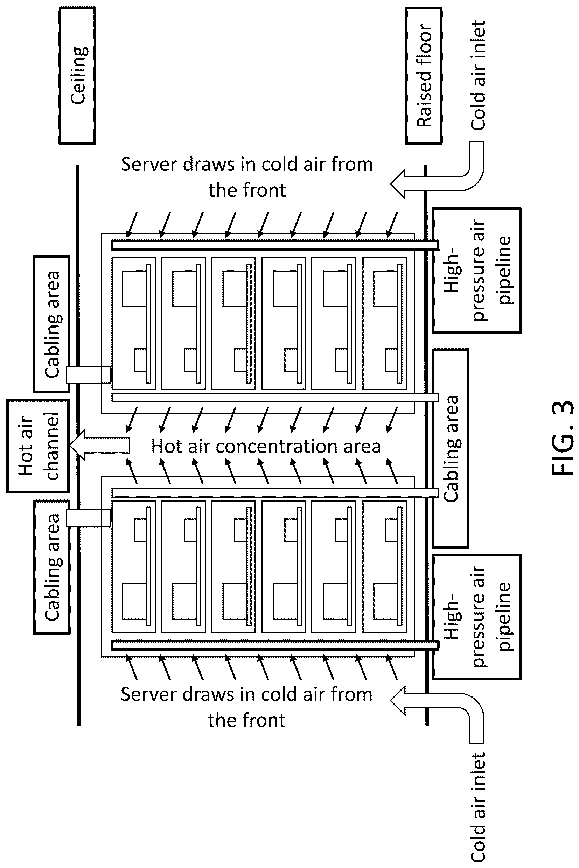

FIG. 3 is an example cross-sectional view of a cooling system using high-pressure air pipeline for managing thermal conditions in a data center, according to one example embodiment. FIG. 3 builds upon the cooling configuration shown in FIG. 2, but introduces an integrated high-pressure air pipeline within each server rack to enhance cooling efficiency by using compressed air and a vortex tube cooler (not shown in FIG. 3). The high-pressure air pipeline is positioned on the outer side but still enclosed within the structure of the server rack itself. It provides compressed air to the vortex tube cooler, offering a more targeted and efficient thermal management solution compared to conventional air-cooled systems.

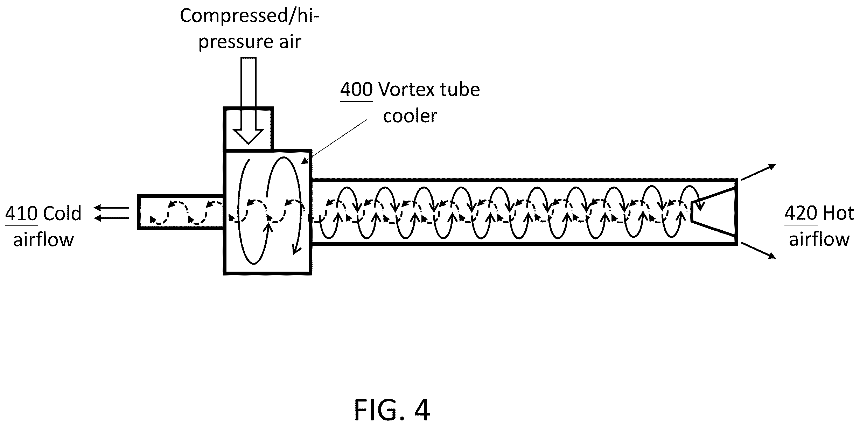

In some embodiments, at least one vortex tube cooler is connected to the high-pressure air pipeline, providing an alternative cooling method that operates independently of the data center's traditional air conditioning system. FIG. 4 provides more detailed explanation on the vortex tube cooler.

The integration of the high-pressure air pipeline and the vortex tube cooler within the server racks provides several advantages over conventional air-cooling methods. Unlike traditional air conditioning systems that cool the entire server room uniformly, the vortex tube cooler delivers cooling precisely to the servers' intake fans, minimizing energy waste and eliminating localized hotspots. This targeted cooling ensures that upper-row servers and racks located at the end of air ducts receive sufficient cooling, addressing the airflow imbalance issues commonly found in traditional cooling configurations. Additionally, since the vortex tube cooler operates solely on compressed air, it functions independently of electrical power, providing a fail-safe cooling mechanism in the event of air conditioning or power system failures.

In addition, the cooling system depicted in FIG. 3 also offers a scalable and modular adaptation for data centers. Multiple vortex tube coolers can be installed within a single server rack, enabling flexible scalability based on cooling demands without requiring major modifications to existing infrastructure. This flexibility is particularly beneficial for AI data centers and other high-performance computing environments, where increasing processing power results in higher thermal loads.

FIG. 4 is an example cross-sectional view of a vortex tube cooler assembly, according to one example embodiment. As shown in FIG. 4, compressed high-pressure air is injected into the vortex tube cooler 400, where the air undergoes rapid rotational motion, leading to the separation of two distinct airflows: a cold airflow 410 and a hot airflow 420.

The vortex tube cooler 400 operates based on the vortex effect, in which compressed air enters the vortex tube cooler chamber at near-sonic speeds. The injected air undergoes a high-speed rotational motion inside the chamber, reaching speeds exceeding one million revolutions per minute. This rapid spinning motion forces a portion of the air to move toward the longer section of the vortex tube cooler, where an adjustable control valve is located. As the air progresses toward this control valve, an inner vortex is formed, which undergoes a reversal in rotational direction. During this reversal process, heat energy is transferred from the inner vortex to the surrounding outer vortex, effectively separating the compressed air into two distinct temperature zones.

The hot airflow 420 is expelled through the longer section of the tube, carrying away the excess heat that was transferred from the inner vortex. Meanwhile, the cold airflow 410 is released from the opposite end of the vortex tube cooler, significantly cooler than the original compressed air. This cooling process occurs without the use of external power sources or chemical refrigerants, relying solely on the thermodynamic effects of the vortex motion. The vortex tube cooler can rapidly separate room-temperature compressed air into two extreme temperature streams, with the cold airflow reaching temperatures as low as -40°C, while the hot airflow can reach up to +110°C.

This separation of hot and cold air provides an efficient, energy-independent cooling mechanism that can be integrated into the data center environments. The ability to generate these two separate air streams from a single compressed air source makes the vortex tube cooler a versatile and effective solution for targeted cooling applications.

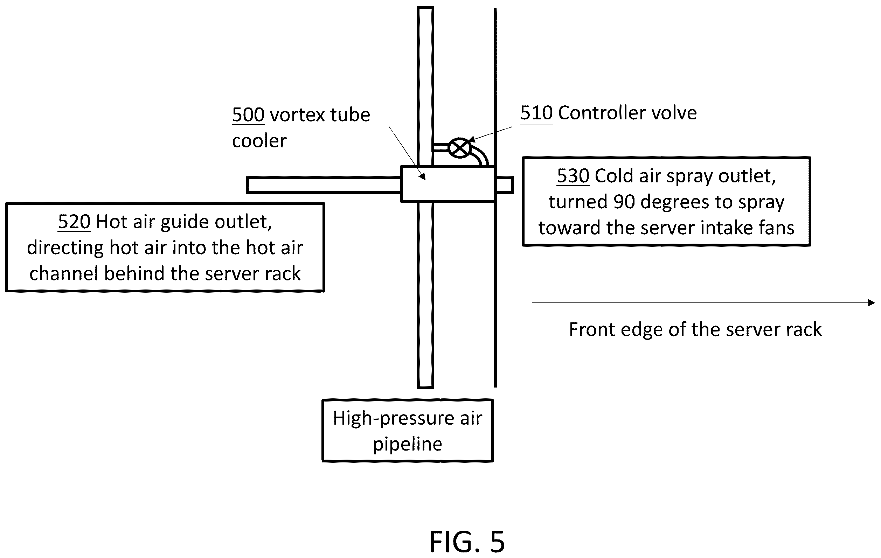

FIG. 5 is an example configuration of the vortex tube cooler 500 and the high-pressure pipeline, according to one example embodiment. As shown, the high-pressure pipeline supplies compressed air to the vortex tube cooler 500 for generating a cold airflow and a hot airflow. A controlling valve 510 is operatively coupled to the high-pressure air pipeline and is configured to regulate the compressed airflow entering the vortex tube cooler 500, thereby allowing dynamic adjustment of the cooling effect based on real-time thermal conditions.

As compressed air enters the vortex tube cooler 500, it undergoes the vortex effect explained in FIG. 4, wherein the air rotates at extremely high speeds, separating into two distinct airflow streams. The hot airflow 520 is directed into a hot air guide outlet, which channels the expelled hot air toward a hot air exhaust assembly located behind the server rack. The cold airflow exits through a cold air spray outlet 530, which extends outward from the vortex tube cooler 500 and may be bent (e.g., at a 90-degree angle) to direct the cold air towards the intake fans of the vertically stacked servers in the server rack.

In some embodiments, the cold air spray outlet 530 extends to enter the front edge of the server rack, allowing cold air to be introduced more precisely into the intake airflow path rather than spraying cold air directly onto internal server components.

The high-pressure air pipeline and the vortex tube cooler 500 integrated within the server rack provide an independent, scalable cooling mechanism that operates without requiring electrical power. Instead, the cooling process relies solely on compressed air, making the system a reliable fail-safe cooling solution in the event of power or air conditioning failures. The controlling valve 510 may be manually or automatically adjusted or may be linked to an automated control system that dynamically modulates airflow based on temperature readings within the server rack. Additionally, the cold air spray outlets 530 may be adjustable, allowing manual or automated control over the direction and spread of the cold airflow toward different regions within the server rack.

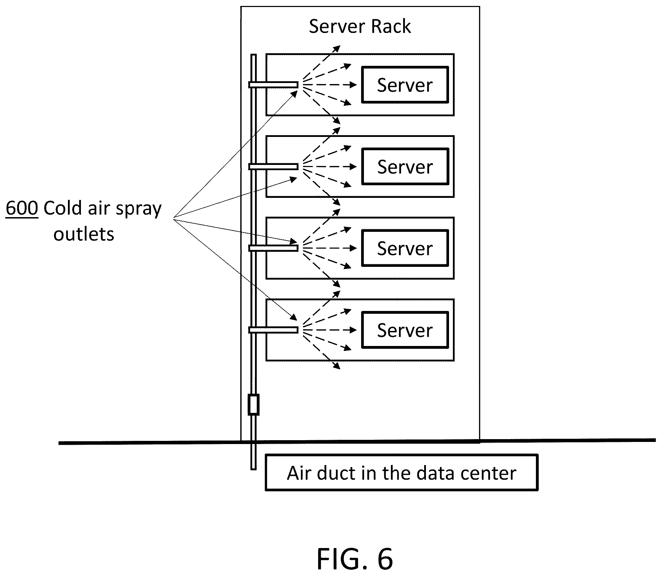

FIG. 6 illustrates an example cross-sectional view of a server rack using the high-pressure air pipeline for managing thermal conditions, according to one example embodiment.

As shown in FIG. 6, the high-pressure air pipeline may be configured to supply compressed air to multiple vortex tube coolers, and each vortex tube cooler is configured with a cold air spray outlet 600 that directs cold air toward the intake fans of the servers. This configuration ensures that the cold airflow enters the front intake fans of the servers, allowing the server's internal airflow system to distribute the cooled air efficiently.

One key advantage of this configuration is that the cold airflow is mixed with ambient air at the intake fans before entering the server. Rather than blowing the extremely cold air from the spray outlets 600 directly onto heat-generating components, which may cause thermal shock and hardware damage, this approach utilizes the server's built-in intake fans to mix cold and ambient air, ensuring uniform cooling. This method allows the server's built-in airflow system to regulate cooling internally, ensuring that all critical components receive adequate cooling without subjecting any single component to extreme temperature shifts. This approach minimizes thermal stress while optimizing airflow distribution, significantly improving the reliability and longevity of server hardware.

In addition, the vortex tube cooler may be connected to a control valve, which can be automatically adjusted or linked to the data center's environmental temperature control system. This integration allows for dynamic cooling regulation, automatically adjusting the cooling effect based on real-time thermal conditions within the data center.

Because the vortex tube cooler operates solely on compressed air and does not require electricity, the above-described configuration may serve as an ideal backup cooling solution for data centers. In cases where air conditioning systems experience temporary failures, this system can function as an emergency cooling mechanism, preventing rapid temperature spikes and ensuring continued operation of critical IT infrastructure. Additionally, since the vortex tube cooler-based cooling system is independent of the primary air conditioning system, increasing air storage capacity or adding additional air compressors can further enhance the overall cooling capability of the data center without requiring major modifications to existing HVAC infrastructure.

In addition, this design also leverages existing compressed air infrastructure, making it more scalable and cost-effective. Unlike naively requiring dedicated vortex tubes for each CPU or heat-generating component, this cooling system enables a single vortex tube cooler (or a small number of them) to cool multiple servers by introducing cold air spray outlets at the intake fans level. Because data centers already utilize compressed air pipelines for other purposes, integrating this system into existing infrastructure requires minimal modification, significantly reducing installation costs.

Another key advantage of this system is its ability to function independently of traditional air conditioning units. Unlike conventional cooling methods that rely on electrically powered air conditioning systems, this system operates purely on compressed air, making it a backup and fail-safe cooling solution in case of power failures or HVAC malfunctions.

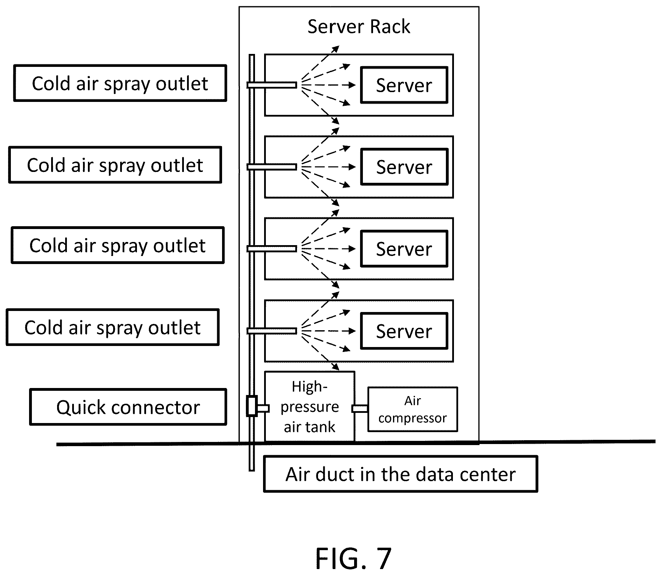

FIG. 7 illustrates another example cross-sectional view of a server rack using the high-pressure air pipeline for managing thermal conditions, according to one example embodiment. FIG. 7 is structurally similar to FIG. 6 but is designed for smaller data centers that do not have pre-existing compressed air supply. This embodiment introduces a localized air compression system within the server rack by incorporating a high-pressure air tank and an air compressor.

In this configuration, a high-pressure air tank is installed within the server rack to store compressed air and release it as needed into the vortex tube cooler. The high-pressure air tank ensures a stable supply of compressed air to drive the cooling process, even in the absence of a centralized high-pressure air pipeline. Additionally, an air compressor is integrated into the system to generate compressed air on-site, supplying it to the high-pressure air tank.

This self-contained compressed air-cooling system presents several advantages for small data centers. First, it eliminates the need for a facility-wide compressed air infrastructure, making it suitable for environments where space, cost, or operational constraints prevent the installation of a centralized high-pressure air pipeline. The modular design allows for easy deployment in existing server racks without significant modifications to the data center's cooling or HVAC infrastructure.

Additionally, this localized compressed air system allows for scalability in small data centers. Increasing the air storage capacity or adding additional air compressors can further enhance the cooling capacity of the system, allowing it to adapt to growing cooling demands without requiring major facility-wide changes.

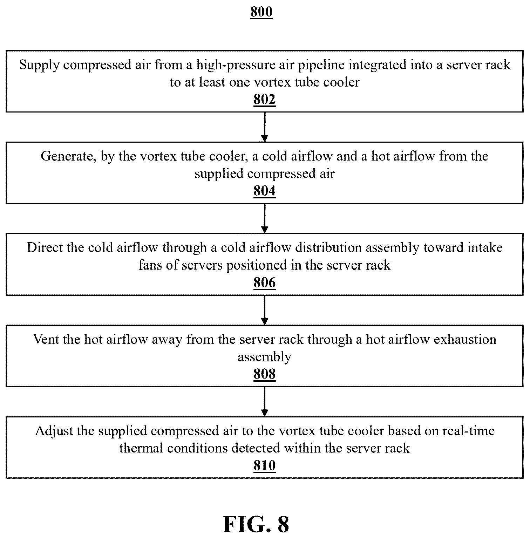

FIG. 8 illustrates an example method for cooling servers in a data center using the high-pressure air pipeline, according to one example embodiment. In some implementations, one or more process blocks of FIG. 8 may be performed by a device.

As shown in FIG. 8, process 800 includes supplying compressed air from a high-pressure air pipeline integrated into a server rack to at least one vortex tube cooler (block 802). For example, the device may supply compressed air from a high-pressure air pipeline integrated into a server rack to at least one vortex tube cooler, as described above.

Process 800 also includes generating, by the vortex tube cooler, a cold airflow and a hot airflow from the supplied compressed air (block 804). For example, the device may generate a cold airflow and a hot airflow from the supplied compressed air using the vortex tube cooler, as described above.

Further, process 800 includes directing the cold airflow through a cold airflow distribution assembly toward the intake fans of servers positioned in the server rack (block 806). For example, the device may direct the cold airflow through a cold airflow distribution assembly toward the intake fans of servers positioned in the server rack, as described above.

Additionally, process 800 includes venting the hot airflow away from the server rack through a hot airflow exhaust assembly (block 808). For example, the device may vent the hot airflow away from the server rack through a hot airflow exhaust assembly, as described above.

Process 800 also includes adjusting the supplied compressed air to the vortex tube cooler based on real-time thermal conditions detected within the server rack (block 810). For example, the device may adjust the supplied compressed air to the vortex tube cooler based on real-time thermal conditions detected within the server rack, as described above.

Although FIG. 8 illustrates example blocks of process 800, in some implementations, process 800 may include additional blocks, fewer blocks, different blocks, or blocks arranged in a different order than depicted in FIG. 8. Additionally, two or more of the blocks in process 800 may be performed in parallel.

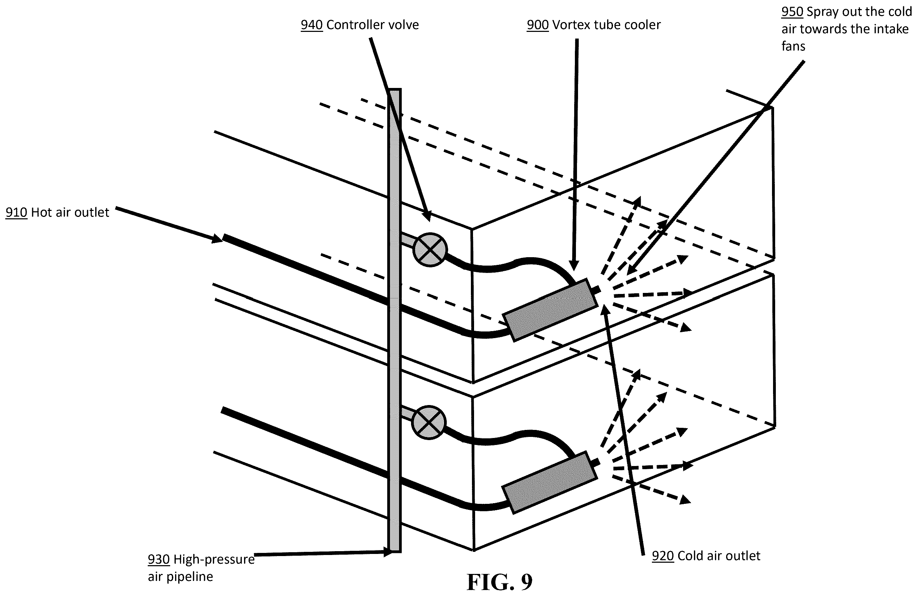

FIG. 9 illustrates an example configuration of the cooling system in a data center, according to one example embodiment. As shown, the system includes a high-pressure air pipeline 930 that is configured vertically and integrated within a server rack. The server rack may include a plurality of chassis, each housing one or more servers or other types of heat-generating components. The high-pressure air pipeline 930 serves as the primary conduit for supplying compressed air to the cooling components within the rack.

The high-pressure air pipeline 930 may have a plurality of extended branches, with each branch connected to a vortex tube cooler 900. These branches independently deliver compressed air to the vortex tube coolers 900, enabling localized and distributed cooling throughout different sections of the server rack. In some embodiments, a controller valve 940 is positioned between the high-pressure air pipeline 930 and each vortex tube cooler 900. This controller valve 940 regulates the amount or speed of compressed air delivered to each vortex tube, allowing the system to dynamically adjust cooling performance based on thermal demand or predefined control logic.

Each vortex tube cooler 900 operates by applying the vortex effect-a power separation mechanism that splits the supplied compressed air into two distinct airflows: a cold airflow and a hot airflow. The hot airflow is expelled from the rear of the server rack via a hot air outlet 910, ensuring that the heat is effectively removed from the enclosure and directed into the hot aisle or heat exhaust system of the data center.

The cold airflow, on the other hand, is directed forward through a cold air outlet 920. The outlet 920 is positioned to spray the cold airflow toward the intake fans 950 of the corresponding chassis. By aligning the cold air outlet with the intake fans 950, the system ensures that the cold air is mixed with ambient air before being drawn into the server. This approach avoids direct cold shock on heat-sensitive electronic components while still achieving effective cooling across the chassis. The use of mixed airflow improves uniform temperature distribution inside the server and extends the lifespan of critical components.

The specific example illustrated in FIG. 9 configures one vortex tube cooler 900 for each chassis within the server rack, enabling precise, per-chassis cooling control. However, a person skilled in the art would readily recognize that this configuration can be modified or scaled based on cooling requirements, system design, or resource constraints. For instance, a single vortex tube cooler 900 may be configured to provide cooling for multiple chassis by splitting the cold airflow and distributing it to multiple cold air outlets positioned in front of different chassis. In some embodiments, a single vortex tube cooler could even be used to cool the entire server rack, using a network of ducts or diverter mechanisms to channel the cold airflow efficiently. Such design variations may reduce the number of vortex tubes needed, simplify installation, and optimize air distribution without departing from the core principles of the invention.

The configuration shown in FIG. 9 demonstrates a modular and scalable approach to integrating vortex tube-based cooling into standard server rack architecture. By positioning a high-pressure air pipeline vertically along the rack and branching it out to multiple vortex tube coolers, the system delivers targeted cooling at various points, tailored to the needs of individual chassis or zones within the rack. The inclusion of controller valves further enables adaptive cooling, where airflow can be adjusted dynamically in response to temperature fluctuations or workload changes.

The foregoing description of the present disclosure has been provided for the purposes of illustration and description. It is not intended to be exhaustive or to limit the disclosure to the precise forms disclosed. The breadth and scope of the present disclosure should not be limited by any of the above-described exemplary embodiments. Many modifications and variations will be apparent to the practitioner skilled in the art. The modifications and variations include any relevant combination of the disclosed features. The embodiments were chosen and described in order to best explain the principles of the disclosure and its practical application, thereby enabling others skilled in the art to understand the disclosure for various embodiments and with various modifications that are suited to the particular use contemplated. It is intended that the scope of the disclosure be defined by the following claims and their equivalence.

## Claims

1. A cooling system for managing thermal conditions in a data center, comprising:
a high-pressure air pipeline integrated into a server rack;
at least one vortex tube cooler connected to the high-pressure air pipeline, wherein compressed air enters the vortex tube cooler from the high-pressure air pipeline, and the vortex tube cooler is configured to generate a cold airflow and a hot airflow from the compressed air;
a cold airflow distribution assembly connected to the vortex tube cooler and configured to direct the cold airflow toward one or more servers in the server rack; and
a hot airflow exhaust assembly connected to the vortex tube cooler and configured to vent the hot airflow away from the server rack.

2. The cooling system of claim 1, further comprising:
a control system operatively coupled to the high-pressure air pipeline and configured to regulate an airflow through the vortex tube cooler based on real-time thermal conditions within the server rack.

3. The cooling system of claim 2, wherein the control system comprises an adjustable valve for adjusting the airflow, or, wherein the control system is configured to receive input from one or more temperature sensors located within the server rack and dynamically adjust the airflow through the vortex tube cooler, or wherein the control system is communicatively linked to a data center environmental control system to synchronize cooling operations with overall data center thermal management.

4. The cooling system of claim 1, wherein the high-pressure air pipeline is integrated with a compressed air supply in the data center.

5. The cooling system of claim 1, wherein the server rack comprises a plurality of chassis, the high-pressure air pipeline is connected to a plurality of vortex tube coolers respectively corresponding to the plurality of chassis, and each of the plurality of vortex tube coolers is configured to spray the cold airflow towards the corresponding chassis.

6. The cooling system of claim 1, wherein the cold airflow distribution assembly comprises one or more cold air spray outlets that are configured adjacent to intake fans of the one or more servers, or wherein the cold airflow sprayed out of one or more cold air spray outlets of the cold airflow distribution assembly is mixed with ambient air before entering intake fans of the one or more servers, preventing direct thermal shock to electronic components.

7. The cooling system of claim 1, wherein the hot airflow exhaust assembly comprises a ducting system that directs the hot airflow away from heat-sensitive components in the server rack.

8. The cooling system of claim 1, wherein the vortex tube cooler operates based on energy separation of the compressed air for generating the cold airflow, or, is configured to adjust the cold airflow at a temperature optimized to prevent condensation and minimize thermal expansion and contraction effects on the servers in the server rack.

9. The cooling system of claim 1, further comprising a fail-safe cooling mechanism wherein, in response to an air conditioning system failure, the cooling system is activated to provide emergency cooling to prevent server overheating.

10. The cooling system of claim 1, wherein a volve is configured between the vortex tube cooler and the high-pressure air pipeline, to adjust an amount and/or a speed of the compressed air enters the vortex tube cooler from the high-pressure air pipeline.

11. The cooling system of claim 1, wherein the vortex tube cooler is adjustable to vary a proportion of the cold and hot airflow based on cooling demands, or is configured with an adjustable spray outlet that allows manual or automated control over the direction and spread of the cold airflow toward different regions within the server rack.

12. The cooling system of claim 1, wherein the cold airflow distribution assembly extends from the vortex tube cooler and directs the cold airflow towards intake fans of the one or more servers positioned on the server rack.

13. The cooling system of claim 1, further comprising a high-pressure air tank configured to store the compressed air and release the compressed air into the vortex tube cooler to generate the cold airflow and the hot airflow.

14. The cooling system of claim 1, further comprising an air compressor configured to generate the compressed air and supply the compressed air to the vortex tube cooler to generate the cold airflow and the hot airflow.

15. A method for cooling servers in a data center, the method comprising:
supplying compressed air from a high-pressure air pipeline integrated into a server rack to at least one vortex tube cooler;
generating, by the vortex tube cooler, a cold airflow and a hot airflow from the supplied compressed air;
directing the cold airflow through a cold airflow distribution assembly toward intake fans of one or more servers positioned in the server rack;
venting the hot airflow away from the server rack through a hot airflow exhaust assembly; and
adjusting the supplied compressed air to the vortex tube cooler based on real-time thermal conditions detected within the server rack.
